Europäisches Patentamt

European Patent Office

Office européen des brevets

(11) Publication number: **0 225 519**
A2

# EUROPEAN PATENT APPLICATION

(21) Application number: **86116093.5**

(22) Date of filing: **20.11.86**

(51) Int. Cl.⁴: **H 01 L 21/82**

(30) Priority: **06.12.85 US 806258**

(43) Date of publication of application: **16.06.87**
**Bulletin 87/25**

(84) Designated Contracting States: **DE FR GB**

(71) Applicant: **TEXAS INSTRUMENTS INCORPORATED,
13500 North Central Expressway, Dallas
Texas 75265 (US)**

(72) Inventor: **Zorindky, Eldon J., 2217 Vickers Drive, Plano
Texas 75075 (US)**
Inventor: **Spratt, David B., 3028 Stanford Drive, Plano
Texas 75075 (US)**

(74) Representative: **Leiser, Gottfried, Dipl.-Ing. et al,
Patentanwälte Prinz, Leiser, Bunke & Partner
Manzingerweg 7, D-8000 München 60 (DE)**

(54) High definition anodized sublayer boundary.

(57)    A semiconductor structure has a high definition boundary
between semiconductor islands (54) and an isolating sublayer
(50) having a transition thickness less than 1500A. To form the
structure a trench (62) is formed in a composite epitaxial layer
(54) and an N⁺ sublayer (50). The sublayer (50) is anodized and
oxidized at a high pressure and low temperature environment,
reducing updiffusion of the N⁺ impurities into the epitaxial
layer (54).

# HIGH DEFINITION ANODIZED SUBLAYER BOUNDARY

## BACKGROUND OF THE INVENTION
### 1. FIELD OF THE INVENTION
The present invention relates to methods for forming semiconductor structures, and more particularly to methods for producing improved isolated semiconductor regions which, in turn, enables fabrication of improved semiconductor devices.

### 2. DESCRIPTION OF THE PRIOR ART
The semiconductor industry has directed continuous effort toward improved bipolar integrated circuits, including bipolar transistors, MOS devices, or both. For example, it has been suggested that horizontal bipolar devices may have certain advantages over traditional vertically oriented structures, and attempts have been made to fabricate such devices. To this end, one area of investigation has been the use of isolation techniques, such as oxygen implantation, in hopes of improving the quality of the resulting bipolar transistor structures. Isolation techniques heretofore employed with MOS circuits, however, have inherent limitations when used to fabricate bipolar devices. One limitation in such isolating techniques is the inherent formation of defects along the boundary between the semiconductor and isolation layer. These defects prevent the formation of closely spaced lateral junctions, and thereby prevent the formation of high gain devices.

Limitations of other isolation techniques include the natural or inherent updiffusion or autodoping of impurities into the semiconductor material, which generally occurs near the isolation boundary. Inherent or naturally occurring lateral diffusion of impurities in the prior isolation techniques also presents a problem, which results in increased leakage and general degradation of the devices constructed.

From the foregoing, it can be seen that a need has arisen for semiconductor structures, and a method of making them which enables the manufacture of high gain horizontal bipolar devices. A related need and also arisen for improved isolation techniques which provide a low defect and highly defined boundary between the semiconductor material and the isolation sublayer.

## SUMMARY OF THE INVENTION
According to the invention there is provided a method for the formation of isolated semiconductor regions or islands which have a sharper transition between the semiconductor regions and the adjacent isolation regions than has been achieved heretofore. By virtue of this sharp transition, and the resulting reduction in boundary defects, the formation of closely spaced bipolar transistor junctions, and thus higher gain bipolar devices is enabled. In the area of MOS device fabrication, improved device isolation can be achieved, reducing the effects of parasitic transistors, including latch up; increasing the radiation hardness of the devices, recucing "single event upsets"; and decreasing the source-substrate capacitance, increasing device switching speeds.

In accordance with a broad aspect of the invention, a heavily doped anodizable N-layer of semiconductor material is deposited on a semiconductor substrate. Any existing interfacial or native oxide on the top surface of the epitaxial layer is then removed to prevent birds beak or birds head formations, and a silicon nitride layer is formed over the epitaxial layer, in the form of pattern masks for defining areas in which deep trenches will be subsequently etched. Deep trenches are then etched through the layered structure to the semiconductor substrate, and a thin oxide layer is grown on the trench sidewalls at a low temperature. The substrate structure is then exposed to an anodizing solution to clean the trench, and an electrical current is applied to the solution to anodize the heavily doped N+ layer, to thereby transform this layer into a single, uniform porous silicon sublayer. Next, the structure is subjected to a rapid, low temperature oxidation process to transform the sublayer into a layer of isolating semiconductor oxide. The low temperature oxidation results in an extremely sharp boundary between the epitaxial layer and the isolating sublayer.

The trench is then filled with an isolating oxide, and planarized to provide a desired surface topography. Isolated islands of epitaxial semiconductor material are thereby provided, having sharply defined boundaries between the isolating sublayer. Because only low temperature processes are involved, the epitaxial material remains relatively unaffected by updiffusion or autodoping, and boundary defects are minimized.

## BRIEF DESCRIPTION OF THE DRAWINGS

Further features of the present invention will become apparent from a description of the fabrication process and structure resulting therefrom, taken in conjunction with the accompanying drawings, in which:

FIGURE 1 is a cross-sectional view of a prior art semiconductor structure showing, by way of example, a typical lateral npn bipolar transistor;

FIGURE 2 is an enlarged cross-sectional view of the prior art bipolar semiconductor structure of FIGURE 1 illustrating boundary defects at the interface between the epitxial silicon and oxide layers;

FIGURE 3 is a graphical depiction comparing the dopant concentration distributions across an epitaxial silicon and oxide boundary of a structure fabricated in accordance with the method of the prior art (dashed line) and accomplished in accordance with the method of the present invention (solid line).

FIGURE 4 is a cross-sectional view of the semiconductor substrate showing the various layers formed thereon in accordance with the present invention;

FIGURE 5 is a cross-sectional view of the trenched semiconductor structure;

FIGURE 6 is a cross-sectional view of the trenched semiconductor structure subjected to an anodizing solution;

FIGURE 7 is a cross-sectional view of the semiconductor anodized structure after oxidation;

FIGURE 8 is a cross-sectional view of the semoconductor structure illustrating resist erosion planarization;

FIGURE 9 is a corss-sectional view of the semiconductor structure illustrating the partially planarized top surface; and

FIGURE 10 is a cross-sectional view of the semiconductor structure, showing the isolated epitaxial tanks formed in accordance with the invention.

## DETAILED DESCRIPTION OF THE PREFERRED EMBODIMENTS

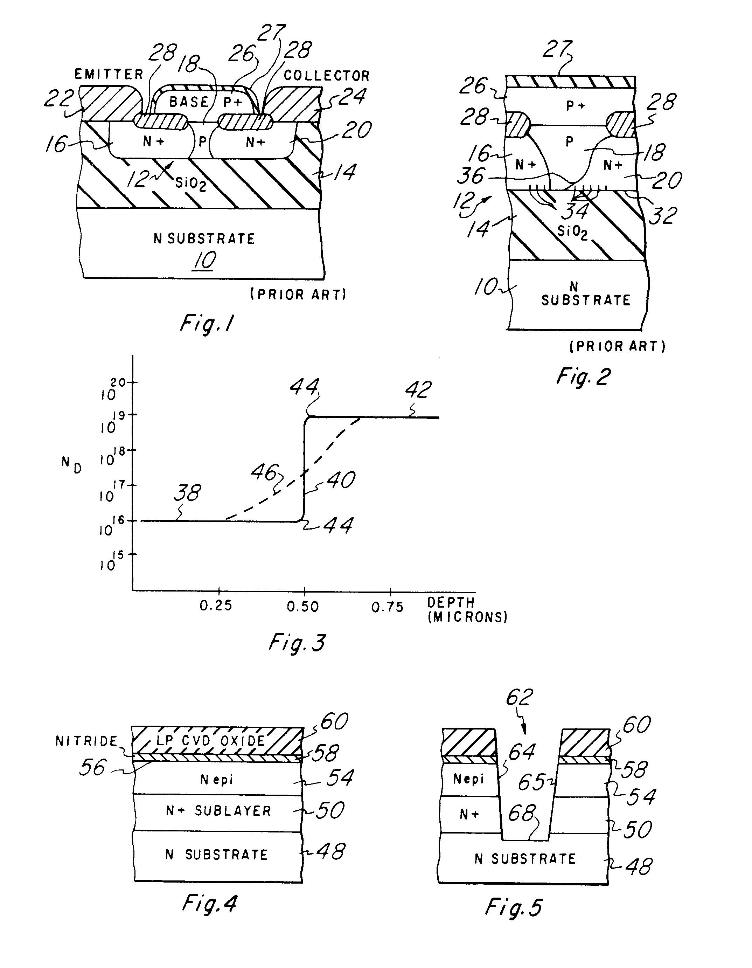

In FIGURE 1 there is shown a horizontal bipolar (npn) transistor structure 11 formed by the techniques of the prior art. (The structure of FIGURE 1 is termed "horizontal" because the device currents flow laterally through the substrate. It will be understood that a horizontal bipolar transistor is described in background only as a suggestion of one of many types of devices which are particularly well suited for fabrication and use after the formation of isolated islands in accordance with the method and structure of the invention. below described in detail. The overall structure includes an N type substrate 10, a semiconductor island region 12, and a silicon dioxide region 14, which isolates the island region 12 from other semiconductor regions (not shown). The transistor formed in the island region 12 includes an N+ emitter 16, a P type base 18 and an N+ collector 20. Metallized contacts 22 and 24 make electrical contact respectively to the emitter 16 an collector 20. A P+ polysilicon layer 26 overlies the base 18, and an oxide film 27 overlies the polisilicon layer 26.

An inherent problem in the fabrication of high quality lateral bipolar devices is the inability to form a sharp transition between the isolating sublayer 14 and the epitaxial semiconductor region 12. The problem is exacerbated when the silicon dioxide isolating layer 14 is formed by anodization methods. With the anodization and oxidation of a heavily doped N+ sublayer to form the silicon dioxide 14, the dopant atoms are driven toward the boundary 32, increasing local N type doping concentrations and forming anodization spikes which represent boundary defects. Thus, with reference to FIGURE 2, a portion of the prior art transistor region 12 of FIGURE 1, greatly enlarged, is shown, illustrating the boundary 32 separating the semiconductor region 12 from the oxide sublayer 14. The boundary defects 34 at the interface between the oxice layer and the N+ regions 16 impair the gain of the device by reducing the quality of the base 18, and are well recognized as an impediment to the formation of a thin base area 18. The boundary defects 34 increase junction leakage currents which degrade the device quality, and more importantly, provide a mechanism for a nonuniform junction diffusion. The nonuniform diffusion created by the boundary defects 34 may result in a base area of nonuniform width, usually with the collector diffusion undercutting the base area, as shown. It is not uncommon, in fact, for the "tail" of the collector base junction to extend to the emitter 16 and short the collector 20 to the emitter 16.

In accordance with the present invention, a sharp interface is provided between the epitaxial silicon and oxide isolation layers, a graphical representation of the interface, contrasted with the interface of the prior art, being shown in FIGURE 3. The vertical axis of the graph indicates dopant concentration, and the horizontal axis indicates the substrate structure depth, measured from the top surface of the epitaxial layer. More particularly, the horizontal line 38 represents the dopant concentration of the epitaxial layer, which is about $10^{16}$ atoms per cubic centimeter. The epitaxial layer is, for example, about one-half micron thick. The vertical line 40 represents the boundary of the transition region. The horizontal line 42 represents the heavily doped N− layer, which is suitable for selective anodization purposes, being doped with a significantly higher concentration ranging from $1 \times 10^{18}$ to $1 \times 10^{19}$ atoms per cubic centimeter. Of significance are the knees 44 between which is the practical boundary dopant gradient achieved according to the process of the invention described in detail below. Preferably, the transition region between the epitaxial and isolation sublayers is not wider than several hundred angstroms.

In contrast, the dashed line 46 illustrates the nonuniformity of epitaxal layer dopant concentration near the boundary, as a result of process techniques heretofore employed. The grandient 46 is a common result of the undesireable characteristics of autodoping and updiffusion occurring during the formation of the epitaxial and oxide sublayer, resulting in a transition region, for instance, between 2500 and 5000Åwide.

FIGURES 4-10 illustrate, in sequence, the process steps, in accordance with the invention, for fabricating high definition epitaxial and oxide sublayer boundaries. With reference first to FIGURE 4, the semiconductor structure is fabricated by first starting with an N type silicon substrate 48, doped, for example, with phosphorous, having a a resistivity of about 2-4 ohm-centimeter. The phosphorus concentration is thus about $10^{15}$ atoms per cubic centimeter of silicon. An N+ sublayer 50 is then formed on the substrate 48. The sublayer 50 is epitaxially grown, rather than being diffused or implanted, so that it has a uniform cross-sectional concentration of dopant. Arsenic, for example, can be used at a concentration of between $10^{18}$ to $10^{19}$ atoms per cubic centimeter to provide the heavily doped nature of the sublayer 50. The thickness of the N+ sublayer 50 is not critical, and can be chosen according to the application desired. The thickness can be, for example, between about 0.25 microns to about 2.0 mircons.

An N-type epitaxial layer 54 is next grown over the N+ sublayer 50. The epitaxial layer 54 is grown with a concentration of dopant, for instance, arsenic, of about $1 \times 10^{15}$ to $1 \times 10^{16}$ atoms per cubic centimeter by conventional reactors so, that the cross-sectional concentration of the arsenic dopant is uniform. The epitaxial layer 54 is the material which will be separated and isolated to constitute the isolated semiconductor regions or tanks.

The top surface of the epitaxial layer 54 is then cleaned by conventional techniques to remove any interfacial or native oxide deposits which may have formed, for instance, as a result of exposure to normal process environments. The removal of any native oxide before depositing subseqent layers of material on the epitaxial surface 56 prevents "birds beak" or "birds head" formations resulting from oxidation of the silicon near exposed edges. These defects are predominant especially in subsequent trenching and oxidizing of the substrate. A thin layer 58 of silicon nitride ($Si_3N_4$) is then deposited on the epitaxial layer 54 to provide an oxidation mask for the top surface of the epitaxial material 54. Finally, a sacrificial oxide layer 60 is deposited on the nitride 58 by a low pressure chemical deposition (LPCVD) process using tetraethyloxysilane (TEOS).

A trench 62 is etched in the semiconductor structure by conventional plasma or reactive ion etching methods as shown in FIGURE 5. The trench 62 extends through the layered semiconductor structure to the substrate 48. To conserve lateral substrate space and provide high density bipolar devices, the trench 62 can be etched with a width of 1 micron, or less. The trench 62 has sidewalls 64 and 66 angled at about 80 to 85 degrees with respect to the trench bottom 68 to eliminate voids during subsequent oxide refill thereof.

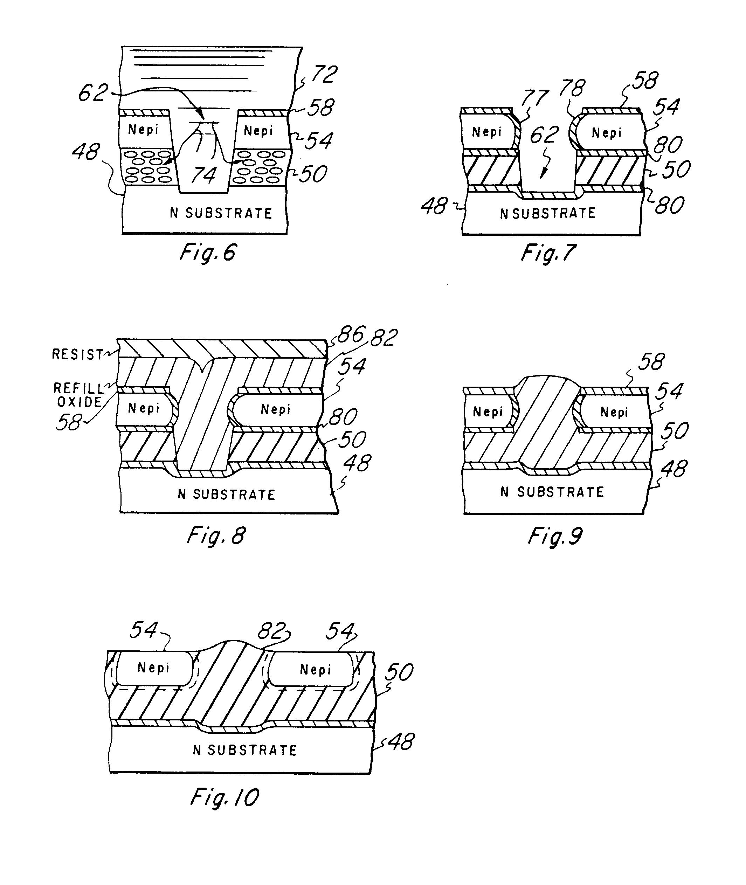

As shown in FIGURE 6, the trenched structure is subjected to anodization by immersing it in an anodization liquid 72 of hydroflouric acid in a solution of about 10% to 49%, by weight, and an electrical potential (not shown) is appled to the liquid 72 on each side of the structure. As a result, current flows from the topside of the structure, through the N+ sublayer 50 and to the bottom of the substrate 48. Since the N+ heavily doped sublayer 50 has a low resistance, it provides a path for concentrated current, as noted by arrows 74. Trenching and anodizing techniques are treated more fully in copending application entitled "Semiconductor Isolation Using Trenches And Oxidation of Anodized Silicon Sublayer", filed concurrently herewith, and accorded serial no. _____, (Attorney's Docket Number TI-10399) assigned to the assignee hereof, and incorporated herein by reference.

As described in said copending patent application serial no. _____, (Attorney's Docket Number TI-10399) anodization occurs first in the heavily doped material, and the more lightly doped material is etched to a lesser degree. For this reason, it should be appreciated that the dopant concentration in the N+ sublayer 50 is uniform therethrough to the epitaxial layer 54, at which point it changes sharply within several hundred angstroms to the epitaxial layer concentration. A large differential in resistivity due to doping concentrations facilitates the complete conversion of the entire N+ layer under and beside the islands 54, producing an abrupt interface with any artifacts eliminated. To that end, prolonged and elevated processing temperatures should be avoided to prevent diffusion of the N+ dopant toward the epitaxial boundary, or into the epitaxial layer 54 itself. The concentration of the uniformly doped epitaxial layer 54 on the uniformly doped N+ layer, together with low temperature, high pressure oxidation processing, to be discussed in detail below, assures that the boundary between the epitaxial material 54 and N+ sublayer 50 remains sharp and highly defined.

The anodization of the N+ sublayer 50 converts the N+ material into a porous sublayer containing pores 76, orinented in the direction of current flow. After the current density of the anodizing process is applied for a sufficient time to produce a porosity of about 50% to 60% in the sublayer 50, the process is halted.

After anodizing the semiconductor structure, the substrate is preconditioned under oxygen at very low temperautre, then deglazed in a 10% hydroflouric acid solution. After deglazing, the substrate is heat treated in a steam atmosphere in which the temperature is slowly increased to about 800-900°C.

The porous silicon sublayer 50 is then completely converted to isolating silicon dioxide by a high pressure and low temperature oxidizing process. This process quickly converts the porous sublayer 50 into silicon dioxide without substantial redistribution of the dopant. Thus, the oxidation of the sublayer 50 minimizes the internal film stresses as well as the dopant redistribution, as above noted. In a preferred embodiment, the pressure can be, for example between 5 and 25 atmospheres, for instance 10 atmospheres, and the temperature less than 900°C, for instance 850°C. The time of reaction is rapid, and depends upon the particular temperature and pressure employed.

FIGURE 7 illustrates the structure after the high pressure oxidation of the sublayer 50. During the oxidation step, the exposed lateral edge of the epitaxial layer 58 is oxidized leaving silicon dioxide edges 77 and 78. In addition, a portion of the substrate 48 and the tub 54 is consumed during the high pressure oxidation process and converted into a thermal silicon dioxide region 80. The region 80 is a bulk density oxide, compared to the anodization oxide of sublayer 50, and acts as a barrier to prevent impurity dopants from passing into the substrate 48. It should be noted that the oxide region 80 is high quality oxide, and presents a highly defined superior interface to the epitaxial layer 54.

To insure thorough oxidation of the porous sublayer 50, and for reflow stress relief of the silicon dioxide in the sublayer 50, the substrate can be subjected to temepratures in excess 970°C for a short duration.

The top surface of the structure is then planarized by a resist erosion planarization method, as shown in FIGURE 8. In the planarization process, the trench 62 is refilled with oxide 82 which also conformally covers the structure surface. As a result of the conformal oxide refill, a cusp 84 may be formed above the trench. A conventional resist 86 is spun over the conformal oxide covering 82, and, since the resist 86 is nonconformal, it fills in the cusp 84 without leaving an irregularity in the top surface of the resist 86. In accordance with the resist erosion technique, a resist is selected which has an etch rate the same as that of the conformal oxide 82, and, when the semiconductor structure is etched, the planar etching boundary moves through the resist 86 as well as the conformal oxide 82, thereby eliminating the cusp 84.

After planarization, the semiconductor substrate appears as shown in FIGURE 9 by lapping the structure and exposing the cross-sectional area of the structure with dilute hydrofluoric acid.

The silicon nitride layer 58 is then removed, as shown in FIGURE 10. The improved semiconductor structure is thus ready for subsequent processing for the lateral formation of bipolar devices in accordance with known techniques.

While the drawings are not to scale, the provision of deep and narrow trenches permit the close spacing of epitaxial tanks 54, and thus a densely packed bipolar circuit. With the provision of epitaxial tanks 54 being fully isolated with silicon dioxide 82, parasitic circuit capacitances are reduced, thereby increasing the switching speed of the bipolar devices. Lastly, and importantly, the islands 54 are not degraded by the formation of imperfections. This feature allows uniform lateral diffusion of the emitter and collector regions in the formation of bipolar devices, so as to form a constant width base region to enable high gain devices.

Although the invention has been described and illustrated with a certain degree of particularity, it is understood that the present disclosure has been made by way of example only and that numerous changes in the combination and arrangement of steps will become apparent to those skilled in the art without departing from the spirit and the scope of the invention as hereinafter claimed.

**WHAT IS CLAIMED IS:**

1. A method of fabricating a silicon semiconductor structure, comprising the steps of:

forming a selectively anodizable layer of material on a substrate;

forming an epitaxial layer on said anodizable layer:

anodizing the anodizable layer to form porous material;

oxidizing said porous material by subjecting the structure to a high pressure and a low temperature oxidizing environment such that the porous layer is oxidized before impurities therein are diffused into said epitaxial layer.

2. The method of claim 1 wherein said oxidation temperature is maintained below 900 degrees C.

3. The method of claim 1 wherein said oxidation temperature is about 850 degrees C.

4. The method of claim 1 wherein said pressure is maintained between 5 and 25 atmospheres.

5. The method of claim 1 wherein said pressure is maintained at about 10 atmospheres.

6. The method of claim 1 wherein said anodizable layer is deposited with a substantially uniform concentration of impurities therethrough.

7. A method of fabricating a semiconductor structure, comprising the steps of:

epitaxially growing a heavily doped N+ layer of semiconductor material on an N type silicon substrate;

epitaxially growing a lightly doped N- layer over said heavily doped N+ layer;

trenching through said epitaxial layers from a top surface of said lightly doped N- layer to said substrate;

anodizing said heavily doped N+ layer to thereby form a porous layer of semiconductor material;

oxidizing said porous layer of semiconductor material at a temperature less than 900°C in a pressure above 5 atmospheres to thereby form a composite layer of silicon dioxide; and

filling said trench with an isolating oxide.

8. The method of claim 7 wherein said oxidation temperature is about 850 degrees C.

9. The method of claim 7 wherein said pressure is maintained between 5 and 25 atmospheres.

10. The method of claim 7 further inlcuding preetching the trenched sidewalls and bottom thereof before anodization.

11. The method of claim 10 wherein said preetching includes soaking said substrate in said anodizing solution for a predetermined period of time before electrical current is applied thereto.

12. The method of claim 7 further including forming a silicon nitride layer on said lightly doped N- layer.

13. A semiconductor structure having isolated islands, comprising:

a silicon dioxide isolating sublayer;

epitaxial silicon islands surrounded by and over said sublayer having a predetermined dopant concentration therethrough; and

a boundary region between said silicon dioxide isolating sublayer and said epitaxial layer having a doping transition thickness less than several hundred angstroms.

14. The semiconductor structure of claim 13, wherein said boundary region transition is from a doping level of about $10^{16}$ to a doping level of between about $10^{18}$ to $10^{19}$ atoms per cubic centimeter.

15. The semiconductor structure of claim 13 wherein said transition thickness is less than 1500Å.

16. The semiconductor structure of claim 13 wherein said transition thickness is less than 500Å.

EMITTER
BASE
COLLECTOR
*Fig. 1*
(PRIOR ART)

*Fig. 2*
(PRIOR ART)

*Fig. 3*

NITRIDE
LP CVD OXIDE
Nepi
N+ SUBLAYER
N SUBSTRATE

*Fig. 4*

Nepi
N+
N SUBSTRATE

*Fig. 5*

Fig. 6

Fig. 7

Fig. 8

Fig. 9

Fig. 10